# EUROPEAN PATENT SPECIFICATION

(11) **EP 4 020 118 B1**
(45) Date of publication and mention of the grant of the patent: **11.06.2025**
(21) Application number: 21196820.1
(22) Date of filing: 15.09.2021
(51) Int. Cl.: G06F 1/16, G06F 1/20

(54) **FLEXIBLE HEAT SPREADER**
FLEXIBLER WÄRMEVERTEILER
DISSIPATEUR DE CHALEUR FLEXIBLE

(30) Priority: 22.12.2020 US 202017131375
(43) Date of publication of application: 29.06.2022
(73) Proprietor: INTEL Corporation, Santa Clara, CA 95054 (US)
(72) Inventor: KURMA RAJU, Prakash, 560068 Bangalore (IN); PICHUMANI, Prasanna, 560076 Bangalore (IN); KANIVIHALLI, Raghavendra S, 560037 Bangalore (IN)
(74) Representative: Rummler, Felix

(56) References cited:
- CN-A- 111 811 305
- US-A1- 2018 092 253
- US-A1- 2019 041 922
- US-A1- 2020 319 672

## Description

### TECHNICAL FIELD

This disclosure relates in general to the field of computing, and more particularly, to a flexible heat spreader.

### BACKGROUND

End users have more electronic device choices than ever before. A number of prominent technological trends are currently afoot (e.g., more computing devices, more devices that can change into different configurations, etc.), and these trends are changing the electronic device landscape. Some emerging trends place increasing performance demands on systems. The increasing demands can cause thermal increases in the system. The thermal increases can cause a reduction in device performance, a reduction in the lifetime of a device, and delays in data throughput.

US 2019/041922 A1 describes a computing apparatus, including: a first chassis including primary operational circuitry of the computing apparatus; a second chassis hingeably coupled to the second chassis, the second chassis having substantially less operational circuitry than the first chassis whereby the operational circuitry of the second chassis generates substantially less heat than the operational circuitry of the first chassis; and a heat spreader between the first chassis and second chassis and disposed to dissipate generated heat from the first chassis into the second chassis.

CN 111 811 305 describes a flexible temperature equalizing plate applied to an electronic device. The temperature equalizing plate comprises an upper cover, a lower cover, a chamber, a capillary structure, a plurality of support units and working fluid contained in the chamber. The temperature equalizing plate can be flexible in a flexible range, and the flexible temperature equalizing plate can be set according to the shape of the electronic device.

### SUMMARY OF INVENTION

The present invention is defined in the independent claims. The dependent claims recite selected optional features.

In the following, each of the described methods, apparatuses, examples, and aspects, which do not fully correspond to the invention as defined in the claims is thus not according to the invention and is, as well as the whole following description, present for illustration purposes only or to highlight specific aspects or features of the claims.

### BRIEF DESCRIPTION OF THE DRAWINGS

To provide a more complete understanding of the present disclosure and features and advantages thereof, reference is made to the following description, taken in conjunction with the accompanying figures, wherein like reference numerals represent like parts, in which:
FIGURE 1A is a simplified block diagram of an electronic device to enable a flexible heat spreader, in accordance with an embodiment of the present disclosure;
FIGURE 1B is a simplified block diagram of an electronic device to enable a flexible heat spreader, in accordance with an embodiment of the present disclosure;
FIGURE 1C is a simplified block diagram of an electronic device to enable a flexible heat spreader, in accordance with an embodiment of the present disclosure;
FIGURE 2 is a simplified block diagram of a top cutaway view of a portion of an electronic device to enable a flexible heat spreader, in accordance with an embodiment of the present disclosure;
FIGURE 3 is a simplified block diagram of a side cutaway view of a portion of an electronic device to enable a flexible heat spreader, in accordance with an embodiment of the present disclosure;
FIGURE 4 is a simplified block diagram cutaway view of a portion of an electronic device to enable a flexible heat spreader, in accordance with an embodiment of the present disclosure;
FIGURE 5A is a simplified block diagram of a side cutaway view of a portion of an electronic device to enable a flexible heat spreader, in accordance with an embodiment of the present disclosure;
FIGURE 5B is a simplified block diagram of a side cutaway view of a portion of an electronic device to enable a flexible heat spreader, in accordance with an embodiment of the present disclosure;
FIGURE 5C is a simplified block diagram of a side cutaway view of a portion of an electronic device to enable a flexible heat spreader, in accordance with an embodiment of the present disclosure;
FIGURE 5D is a simplified block diagram of a side cutaway view of a portion of an electronic device to enable a flexible heat spreader, in accordance with an embodiment of the present disclosure;
FIGURE 5E is a simplified block diagram of a side cutaway view of a portion of an electronic device to enable a flexible heat spreader, in accordance with an embodiment of the present disclosure;
FIGURE 6 is a simplified block diagram of a side cutaway view of a portion of an electronic device to enable a flexible heat spreader, in accordance with an embodiment of the present disclosure;
FIGURE 7A is a simplified block diagram of a side cutaway view of a portion of an electronic device to enable a flexible heat spreader, in accordance with an embodiment of the present disclosure;
FIGURE 7B is a simplified block diagram of a side cutaway view of a portion of an electronic device to enable a flexible heat spreader, in accordance with an embodiment of the present disclosure;
FIGURE 8A is a simplified block diagram of a portion of an electronic device to enable a flexible heat spreader, in accordance with an embodiment of the present disclosure;
FIGURE 8B is a simplified block diagram of a portion of an electronic device to enable a flexible heat spreader, in accordance with an embodiment of the present disclosure;
FIGURE 8C is a simplified block diagram of a portion of an electronic device to enable a flexible heat spreader, in accordance with an embodiment of the present disclosure; and
FIGURE 9 is a simplified block diagram of a portion of an electronic device to enable a flexible heat spreader, in accordance with an embodiment of the present disclosure.

The FIGURES of the drawings are not necessarily drawn to scale, as their dimensions can be varied considerably without departing from the scope of the present disclosure.

### DETAILED DESCRIPTION

### EXAMPLE EMBODIMENTS

The following detailed description sets forth examples of apparatuses, methods, and systems relating to a system for enabling a flexible heat spreader. Features such as structure(s), function(s), and/or characteristic(s), for example, are described with reference to one embodiment as a matter of convenience; various embodiments may be implemented with any suitable one or more of the described features.

In the following description, various aspects of the illustrative implementations will be described using terms commonly employed by those skilled in the art to convey the substance of their work to others skilled in the art. However, it will be apparent to those skilled in the art that the embodiments disclosed herein may be practiced with only some of the described aspects. For purposes of explanation, specific numbers, materials, and configurations are set forth in order to provide a thorough understanding of the illustrative implementations. However, it will be apparent to one skilled in the art that the embodiments disclosed herein may be practiced without the specific details. In other instances, well-known features are omitted or simplified in order not to obscure the illustrative implementations.

The terms "over," "under," "below," "between," and "on" as used herein refer to a relative position of one layer or component with respect to other layers or components. For example, one layer disposed over or under another layer may be directly in contact with the other layer or may have one or more intervening layers. Moreover, one layer disposed between two layers may be directly in contact with the two layers or may have one or more intervening layers. In contrast, a first layer "directly on" a second layer is in direct contact with that second layer. Similarly, unless explicitly stated otherwise, one feature disposed between two features may be in direct contact with the adjacent features or may have one or more intervening layers.

In the following detailed description, reference is made to the accompanying drawings that form a part hereof wherein like numerals designate like parts throughout, and in which is shown, by way of illustration, embodiments that may be practiced. It is to be understood that other embodiments may be utilized and structural or logical changes may be made without departing from the scope of the present disclosure. Therefore, the following detailed description is not to be taken in a limiting sense. For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). Reference to "one embodiment" or "an embodiment" in the present disclosure means that a particular feature, structure, or characteristic described in connection with the embodiment is included in at least one embodiment. The appearances of the phrase "in one embodiment" or "in an embodiment" are not necessarily all referring to the same embodiment. The appearances of the phrase "for example," "in an example," or "in some examples" are not necessarily all referring to the same example.

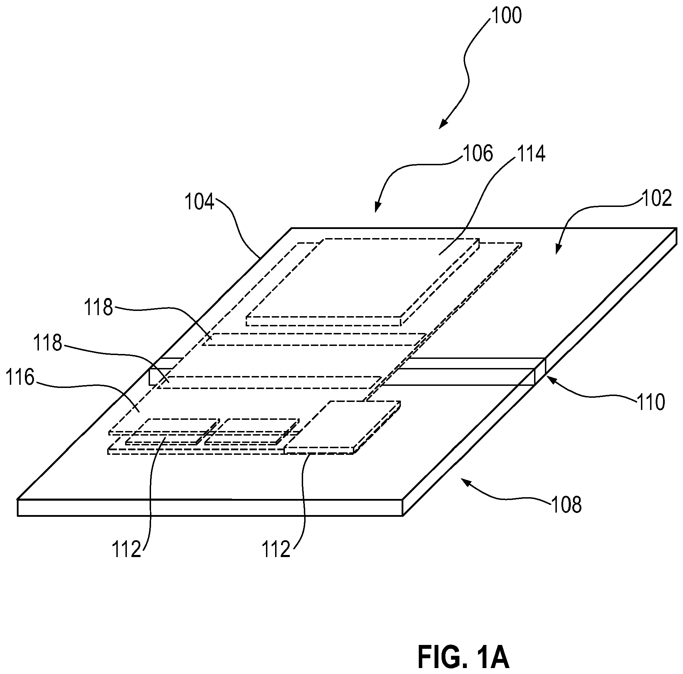

FIGURE 1A is a simplified block diagram of an electronic device 100 configured with a flexible heat spreader, in accordance with an embodiment of the present disclosure. In an example, electronic device 100 can include a flexible display 102 and a chassis 104. Chassis 104 can include a first portion chassis 106, a second portion chassis 108, and a hinge 110. Flexible display 102 may be a foldable organic light emitting diode (FOLED) display or some other flexible display. First portion chassis 106 can be rotatably or pivotably coupled to second portion chassis 108 using hinge 110. Electronic device 100 can also include one or more heat sources 112 and a heatsink 114. More specifically, first portion chassis 106 can include one or more heat sources 112 and second portion chassis 108 can include heatsink 114. Heatsink 114 may be an active heatsink or a passive heatsink.

A flexible heat spreader 116 can extend from one or more heat sources 112 in first portion chassis 106, through hinge 110, and to heatsink 114 in second portion chassis 108. Flexible heat spreader 116 can be comprised of graphite, graphene, copper, aluminum, or some other flexible thermo-conductive material that can transfer heat from one or more heat sources 112 in first portion chassis 106, through hinge 110, and to heatsink 114 in second portion chassis 108. Flexible heat spreader 116 can include one or more frills 118. In an example, at least a portion of flexible heat spreader 116 can be secured to first portion chassis 106, hinge 110, and or second portion chassis 108 using a glue and/or adhesive.

Frills 118 can be configured to accommodate the change in position of the material in flexible heat spreader 116 such that the material in flexible heat spreader 116 is not creased, folded, warped, or otherwise damaged as electronic device 100 is bent or folded (e.g., first portion chassis 106 is rotated about hinge 110 relative to second portion chassis 108). The design or configuration of frills 118 creates a slope and the slope can accommodate the displacement of flexible heat spreader 116 as electronic device 100 moves from zero to one-hundred and eighty (180) degrees. Frills 118 can also be configured to mitigate the slack length as electronic device 100 is opened and closed. The dimensions of frills 118 are based on design constraints, hinge design, the displacement of flexible heat spreader 116 that needs to be accommodated, the slack length of flexible heat spreader 116 that needs to be accommodated, and/or other factors. In a specific example, the height of each frill 118 is about 1.5 millimeter and the length can be about three (3) millimeters. The term "about" indicates a tolerance of ten percent (10%). For example, about one (1) would include one (1) millimeter and ± 0.1 millimeter from one (1) millimeter. Frills 118 can be located proximate to hinge 110 where space will allow for frills 118. As illustrated in FIGURE 1A, electronic device 100 is in an open flat configuration.

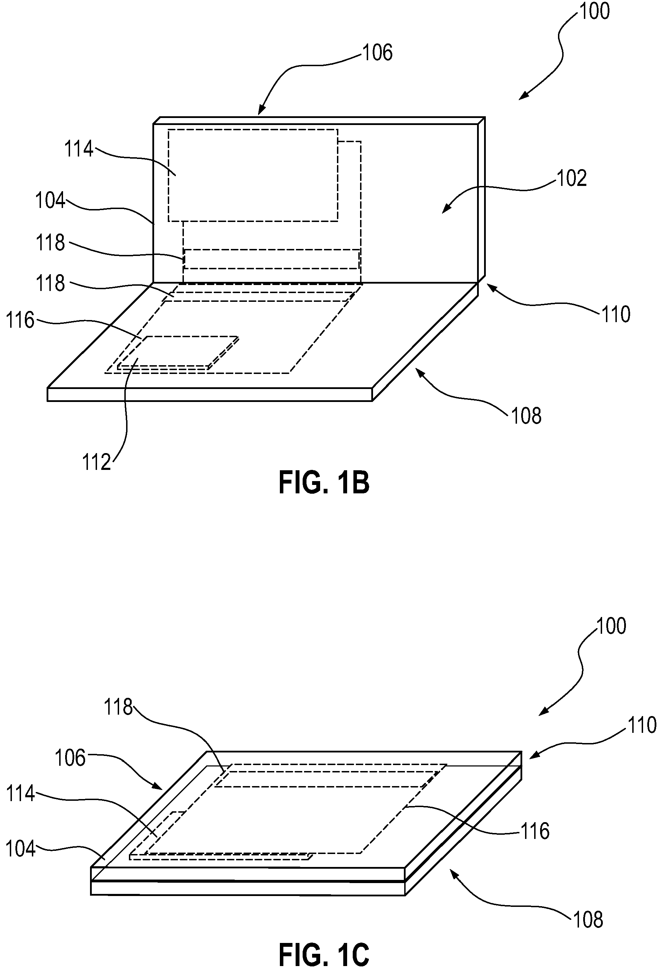

Turning to FIGURE 1B, as illustrated in FIGURE 1B, electronic device 100 can include flexible display 102 and chassis 104. Chassis 104 can include first portion chassis 106, second portion chassis 108, and hinge 110. As illustrated in FIGURE 1B, electronic device 100 can be bend to an open or laptop configuration. More specifically, first portion chassis 106 can be rotated about hinge 110 towards second portion chassis 108 such that electronic device 100 is in an open or laptop configuration. Electronic device 100 can also include one or more heat sources 112 and heatsink 114. More specifically, first portion chassis 106 can include one or more heat sources 112 and second portion chassis 108 can include heatsink 114. Heatsink 114 may be an active heatsink or a passive heatsink.

Flexible heat spreader 116 can extend from one or more heat sources 112 in second portion chassis 108, through hinge 110, and to heatsink 114 in first portion chassis 106. Flexible heat spreader 116 can include one or more frills 118. Frills 118 can be configured to accommodate the change in position of the material in flexible heat spreader 116 such that the material in flexible heat spreader 116 is not creased, folded, warped, or otherwise damaged as electronic device 100 is bent or folded.

Turning to FIGURE 1C, as illustrated in FIGURE 1C, electronic device 100 can include flexible display 102 (not shown) and chassis 104. Chassis 104 can include first portion chassis 106, second portion chassis 108, and hinge 110. As illustrated in FIGURE 1C, electronic device 100 can be bent to a closed configuration. More specifically, first portion chassis 106 can be bent or rotated about hinge 110 towards second portion chassis 108 such that flexible display 102 is bent and electronic device 100 is in a closed configuration with flexible display 102 facing inward. Electronic device 100 can also include one or more heat sources 112 (not shown) and heatsink 114. More specifically, first portion chassis 106 can include one or more heat sources 112 and second portion chassis 108 can include heatsink 114. Heatsink 114 may be an active heatsink or a passive heatsink.

Flexible heat spreader 116 can extend from one or more heat sources 112 in second portion chassis 108, through hinge 110, and to heatsink 114 in first portion chassis 106. Flexible heat spreader 116 can include one or more frills 118. Frills 118 can be configured to accommodate the change in position of the material in flexible heat spreader 116 such that the material in flexible heat spreader 116 is not creased, folded, warped, or otherwise damaged as electronic device 100 is bent or rotated. As used herein, the term "bend," (and its derivatives) includes "curve," "fold," "rotate," and other similar terms that connote moving one end of an object towards an opposite end of the object (e.g., moving first portion chassis 106 towards second portion chassis 108).

Flexible heat spreader 116 can enable a heat transfer of at least a portion of heat from heat source 112 in second portion chassis 108, across hinge 110, and to heatsink 114 in first portion chassis 106. In some examples, flexible heat spreader 116 can be over heat source 112. In other examples, flexible heat spreader 116 can be over a heat pipe or some other rigid heat spreader and the heat pipe or other rigid heat spreader can be over heat source 112. The heat pipe or other rigid heat spreader can collect thermal energy from heat source 112 and transfer the collected thermal energy to flexible heat spreader 116. In an example implementation, flexible heat spreader 116 can be coupled to the chassis of first portion chassis 106. Heat source 112 may be a processor, computer processing unit (CPU), graphics processing unit (GPU), battery, memory, or some other type of component or element in electronic device 100 that generates heat.

In an example, flexible heat spreader 116 can be configured to go through hinge 110 and transfer the heat from heat source 112 in second portion chassis 108 to heatsink 114 in first portion chassis 106 where there is more surface area and the increased surface area can provide relatively better cooling and dissipation of the thermal energy from heat source 112. More specifically, transferring the heat from heat source 112 in second portion chassis 108 to heatsink 114 in first portion chassis 106 allows for more area to transfer heat to the environment and away from electronic device 100. In an example, flexible heat spreader 116 can extend the length of chassis and up to the hinge locations in width based on available chassis dimensions. In a specific illustrative example, flexible heat spreader 116 can be about three hundred millimeters (300) by about two hundred (200) millimeters, or some other dimensions based on design constrains and/or other factors.

When first portion chassis 106 is bent on hinge 110 relative to second portion chassis 108, flexible heat spreader 116 is bent in the hinge area. As flexible heat spreader 116 is bent, it experiences a distortion such that material nearer the outside convex surface of the bend is forced to stretch and come into tension, while material nearer the inside concave surface of the bend is forced into compression. In the cross section of flexible heat spreader 116, there is a plane called a neutral axis that separates the tension and compression zones. The neutral axis is an area within the bend where the material of flexible heat spreader 116 goes through no physical change during forming of the bend. During bending, on the outside of the neutral axis, the material of flexible heat spreader 116 is expanding while on the inside of the neutral axis the material of flexible heat spreader 116 is compressing. This causes the inside surface of flexible heat spreader 116, being inside of the bent neutral axis, to bend to a smaller radius than the outside of the bent neutral axis due to the bending arc length of the inside surface of flexible heat spreader 116 being smaller than the bending arc length of the outside surface of flexible heat spreader 116. As a result, during bending, the material on the outside of flexible heat spreader 116 will move further than the material on the inside of flexible heat spreader 116 and can become creased, folded, warped, or otherwise damaged. Also, as electronic device 100 is bent, it experiences a distortion such that material nearer the outside convex surface of the bend is forced to stretch and come into tension, while material nearer the inside concave surface of the bend comes into compression. On the outside of the neutral axis, the material of electronic device 100 is expanding while on the inside of the neutral axis, the material of electronic device 100 is compressing. This causes the inside surface, which includes flexible heat spreader 116, to extend outside or past the outside surface, which includes chassis 104. More specifically, flexible heat spreader 116, being inside of the bent neutral axis of electronic device, needs to bend to a smaller radius due to the bending arc length of flexible heat spreader 116 being smaller than the bending arc length of chassis 104 and therefore, the ends of flexible heat spreader 116 will move further and are longer than the ends of chassis 104. To help keep the ends of flexible heat spreader 116 from moving relative to chassis 104, the ends of flexible heat spreader 116 can be secured to chassis 104. Frills 118 can be configured to accommodate the change in position of the material in flexible heat spreader 116 such that the material in flexible heat spreader 116 is not creased, folded, warped, or otherwise damaged as first portion chassis 106 is bent on hinge 110 relative to second portion chassis 108.

Flexible heat spreader 116 can be configured as a thermal cooling device to help remove thermal energy from one or more heat sources. Heatsink 114 in first portion chassis 106 may be a passive cooling device or an active cooling device. In an example, heatsink 114 can be coupled to or include an active cooling device to help reduce the thermal energy or temperature of one or more heat sources. In addition, second portion chassis 108 may include one or more passive cooling devices and/or active cooling devices to help remove thermal energy from one or more heat sources in second portion chassis 108. The one or more passive cooling devices and/or active cooling devices in second portion chassis 108 may be independent of flexible heat spreader 116 or may function in concert with flexible heat spreader 116.

In a specific example, flexible heat spreader 116 is coupled to a rigid or semi rigid heat spreader over a heat source (e.g., heat source 112). The term "rigid heat spreader" and "semi-rigid heat spreader" include a cold plate, heat pipe, vapor chamber, and other rigid or semi-rigid heat spreaders. The heat from the heat source is collected by the rigid or semi rigid heat spreader and transferred to flexible heat spreader 116. Flexible heat spreader 116 transfers the heat through hinge 110 and to heatsink 114 in first portion chassis 106. Hinge 110 can include a support that helps support flexible heat spreader 116 and allows frills 118 in flexible heat spreader 116 to dynamically vary the dimension of the material in flexible heat spreader 116 by absorbing the slack that is created when first portion chassis 106 is bent on hinge 110 relative to second portion chassis 108. In some examples, at least a portion of flexible heat spreader 116 can be coupled to the chassis of electronic device 100. In some examples, heat collected by flexible heat spreader 116 is dissipated to chassis 104. In a specific example, electronic device 100 does not include heatsink 114 and the heat collected by flexible heat spreader 116 is dissipated to chassis 104.

It is to be understood that other embodiments may be utilized and structural changes may be made without departing from the scope of the present disclosure. Substantial flexibility is provided by electronic device 100 in that any suitable arrangements and configuration may be provided without departing from the teachings of the present disclosure.

For purposes of illustrating certain example techniques of electronic device 100, the following foundational information may be viewed as a basis from which the present disclosure may be properly explained. End users have more media and communications choices than ever before. A number of prominent technological trends are currently afoot (e.g., more computing elements, more online video services, more Internet traffic, more complex processing, etc.), and these trends are changing the expected performance of devices as devices and systems are expected to increase performance and function. However, the increase in performance and/or function causes an increase in the thermal challenges of the devices and systems.

For example, in some devices, it can be difficult to cool one or more heat sources, especially when the heat sources are relatively close together and/or are located inside a relatively crowded housing that includes memory, processors, battery, etc. The relatively crowded housing can make it difficult to locate thermal solutions inside the crowded housing. In addition, typically the crowded housing acts as a base and is against a flat surface such as a table so it can be difficult to facilitate the movement of air inside the base and dissipate heat from a heat source. Further, in passively cooled systems, there is strong need to reduce the system thickness and at the same time increase the thermal performance. Designing thinner devices is constrained and limited by cooling capability and a cooling budget limitation that comes from the restriction of a thermal solution that can be designed in the base side alone without increasing the thickness of the system.

One solution is to transfer the heat from the crowded housing to a housing that is not crowded. For example, transferring heat from a base of a laptop to the lid provides more area to reject the heat to the environment. However, the base is typically coupled to the lid using a hinge and to transfer the heat from the base to the lid, the heat transfer device needs to go through the hinge.

Some current systems may use a rigid heat pipe as the pin of a system hinge where the system attempts to transfer the heat across the gap between the heat pipe pin and an inner surface of the hinge cylinder. However, with this system, a sliding surface between the heat pipe pin and outer portion of the hinge is required and there is typically a high thermal resistance across the sliding surface. Other current systems may use a flexible heat pipe where the lid is connected to the base by a flexible heat pipe that is perpendicular to the hinge axis. However, a flexible heat pipe requires a relatively large bend radius to avoid failure. Typically, the minimum bend radius for a flexible heat pipe is about or greater than twenty-five (25) millimeters and hinged devices often experience a full deflection of approximately one hundred and fifty (150) degrees, which results in tight bend radius for the heat pipe where strains are concentrated on the bending area of the heat pipe. The tight bend radius can cause reliability problems and will often fail under fatigue loading. Further, a flexible heat pipe is not suitable for thin clamshell solutions, because for thin clamshell systems, the bending radius should be less than ten (10) millimeters while the minimum bend radius for a flexible heat pipe is typically about or greater than twenty-five (25) millimeters. In addition, the large bend radius of the flexible heat pipe can make the system odd-shaped. What is needed is a flexible heat spreader that can allow for the transfer of heat from one portion of a chassis to another portion of the chassis across the hinge area.

A flexible heat spreader, as outlined in FIGURES 1A-1C, can help to resolve these issues (and others). For example, an electronic device (e.g., electronic device 100) can be configured to allow for a flexible heat spreader that can transfer heat from one portion of a chassis to another portion of the chassis across the hinge area. More specifically, the electronic device can be configured to include a flexible heat spreader that can enable a heat transfer of at least a portion of heat from a heat source (e.g., computer processing unit (CPU), graphics processing unit (GPU), etc.) in one portion of a chassis (e.g., second portion chassis 108), through a hinge (e.g., hinge 110), and to a heatsink (e.g., heatsink 114) in another portion of the chassis (e.g., first portion chassis 106). The other portion of the chassis can be used for heat dissipation because it has a large surface area and it is often nearly vertical during use. Transferring heat with low resistance from one portion of the chassis to another portion of the chassis enables higher performance from the heat source and/or a quieter thinner system than some current designs.

In an example, an electronic device can be configured to support a flexible heat spreader in a lay-flat mode. The flexible heat spreader can include frills that allow the flexible heat spreader to have an even bend from about zero degrees (0°) to about one hundred and eighty degrees (180°) of rotation or from about zero degrees (0°) to about three-hundred and sixty degrees (360°) of rotation without damaging the flexible heat spreader. The flexible heat spreader can include graphite, copper, aluminum, or some other flexible material that can be used as a heat spreader for the electronic device and be configured to help increase the thermal performance of the electronic device while the system "Z" thickness is not significantly increased. The flexible heat spreader can be configured to include frills that dynamically support the flexible heat spreader to accommodate the change in position of the material in the flexible heat spreader during rotation of the electronic device at various angles and up to three-hundred and sixty degrees (360⁰) such that the material in the flexible heat spreader is not creased, folded, warped, or otherwise damaged during the rotation.

Electronic device 100 may include any suitable hardware, software, components, modules, or objects that facilitate operations thereof, as well as suitable interfaces for receiving, transmitting, and/or otherwise communicating data or information in a network environment. This may be inclusive of appropriate algorithms and communication protocols that allow for the effective exchange of data or information. Electronic device 100 may include virtual elements.

In regards to the internal structure associated with electronic device 100, electronic device 100 can include memory elements for storing information to be used in operations or functions. Electronic device 100 may keep information in any suitable memory element (e.g., random access memory (RAM), read-only memory (ROM), erasable programmable ROM (EPROM), electrically erasable programmable ROM (EEPROM), application specific integrated circuit (ASIC), etc.), software, hardware, firmware, or in any other suitable component, device, element, or object where appropriate and based on particular needs. Any of the memory items discussed herein should be construed as being encompassed within the broad term 'memory element.' Moreover, the information being used, tracked, sent, or received in electronic device 100 could be provided in any database, register, queue, table, cache, control list, or other storage structure, all of which can be referenced at any suitable timeframe. Any such storage options may also be included within the broad term 'memory element' as used herein.

In certain example implementations, functions may be implemented by logic encoded in one or more tangible media (e.g., embedded logic provided in an ASIC, digital signal processor (DSP) instructions, software (potentially inclusive of object code and source code) to be executed by a processor, or other similar machine, etc.), which may be inclusive of non-transitory computer-readable media. In some of these instances, memory elements can store data used for operations. This includes the memory elements being able to store software, logic, code, or processor instructions that are executed to carry out the activities.

Additionally, electronic device 100 may include one or more processors that can execute software or an algorithm to perform activities. A processor can execute any type of instructions associated with the data to achieve one or more operations. In one example, the processors could transform an element or an article (e.g., data) from one state or thing to another state or thing. In another example, activities may be implemented with fixed logic or programmable logic (e.g., software/computer instructions executed by a processor) and electronic device 100 could include some type of a programmable processor, programmable digital logic (e.g., a field programmable gate array (FPGA), an erasable programmable read-only memory (EPROM), an electrically erasable programmable read-only memory (EEPROM)) or an ASIC that includes digital logic, software, code, electronic instructions, or any suitable combination thereof. Any of the potential processing elements and modules described herein should be construed as being encompassed within the broad term 'processor.'

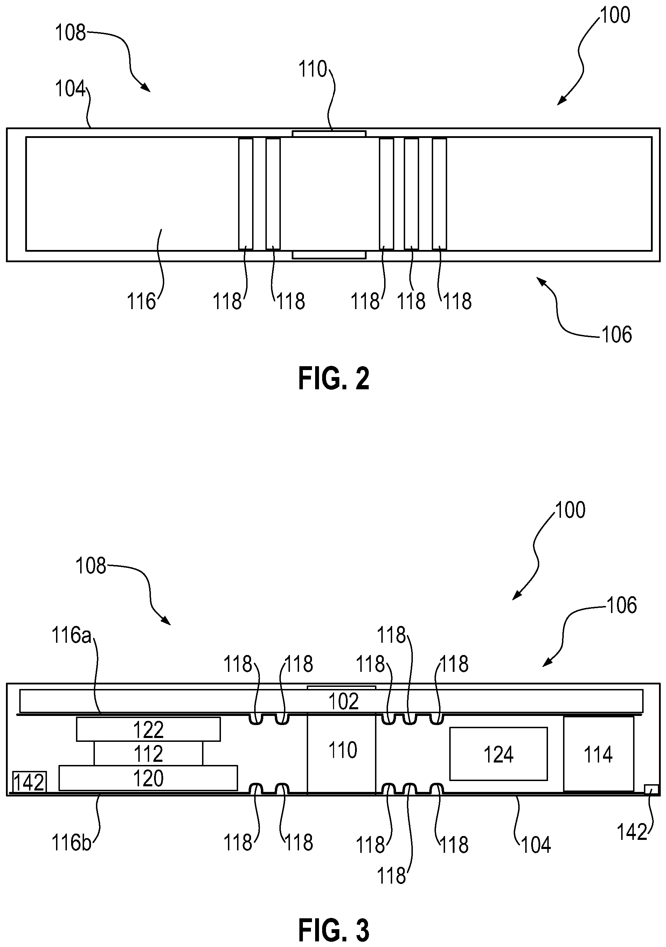

Turning to FIGURE 2, FIGURE 2 is a simplified block diagram of a top cutaway view of electronic device 100 configured with a flexible heat spreader, in accordance with an embodiment of the present disclosure. In an example, electronic device 100 can include a flexible display 102 (not shown) and chassis 104. Chassis 104 can include first portion chassis 106, second portion chassis 108, and hinge 110. First portion chassis 106 can be rotatably coupled to second portion chassis 108 using hinge 110. Flexible heat spreader 116 can extend from first portion chassis 106, through hinge 110, and to second portion chassis 108. Flexible heat spreader 116 can include one or more frills 118. When electronic device is bent, frills 118 can be configured to accommodate the change in position of the material in flexible heat spreader 116 such that the material in flexible heat spreader 116 is not creased, folded, warped, or otherwise damaged as electronic device 100 is bent or folded (e.g., first portion chassis 106 is bent about hinge 110 relative to second portion chassis 108). The number and location of frills 118 depends on design constraints and the number and location that will help to prevent the material in flexible heat spreader 116 from being creased, folded, warped, or otherwise damaged as electronic device 100 is bent or folded. For example, as illustrated in FIGURE 2, first portion chassis 106 includes three (3) frills 118 while second portion chassis 108 includes two (2) frills 118. In an illustrative example, most of the electronics for electronic device 100 are located in second portion chassis 108 so there is only enough room for two (2) frills 118.

Turning to FIGURE 3, FIGURE 3 is a simplified block diagram of side cutaway view of electronic device 100 configured with a flexible heat spreader, in accordance with an embodiment of the present disclosure. In an example, electronic device 100 can include flexible display 102 and chassis 104. Chassis 104 can include first portion chassis 106, second portion chassis 108, and hinge 110. Flexible display 102 may be a FOLED display or some other flexible display. First portion chassis 106 can be rotatably coupled to second portion chassis 108 using hinge 110. Electronic device 100 can also include one or more heat sources 112 and heatsink 114. More specifically, first portion chassis 106 can include one or more heat sources 112, substrate 120, and cold plate 122. Second portion chassis 108 can include heatsink 114 and a battery 124. Heat source 112 can be over or on substrate 120. Cold plate 122 can be thermally coupled to heat source 112 to help remove heat or thermal energy from heat source 112. Cold plate 122 can be coupled to a flexible heat spreader 116a to help move the heat from heat source 112 away from heat source 112 and to heatsink 114 in second portion chassis 108. Heatsink 114 can be an active heatsink or a passive heatsink.

Flexible heat spreader 116a can extend from one or more heat sources 112 in first portion chassis 106, through hinge 110, and to heatsink 114 in second portion chassis 108. In some examples, a flexible heat spreader 116b can extend from substrate 120 in first portion chassis 106, through hinge 110, and to heatsink 114 in second portion chassis 108. In addition, flexible heat spreader 116a and /or 116b can be secured to chassis 104 (or some other structure or component of electronic device 100) using flexible heat spreader securing means 142. Flexible heat spreader securing means 142 can be configured to help keep flexible heat spreaders 116a and/or 116b from moving relative to chassis 104 (or some other structure or component of electronic device 100).

Each of flexible heat spreaders 116a and 116b can include one or more frills 118. In some examples, the frills can interweave so the peaks and valleys of the frills interlace. Frills 118 can be configured to accommodate the change in position of the material in flexible heat spreader 116a and 116b such that the material in flexible heat spreader 116a and 116b is not creased, folded, warped, or otherwise damaged as electronic device 100 is bent or folded (e.g., first portion chassis 106 is bent about hinge 110 relative to second portion chassis 108). The number and location of frills 118 depends on design constraints and the number and location that will help to prevent the material in flexible heat spreader 116a and 116b from being creased, folded, warped, or otherwise damaged as electronic device 100 is bent or folded. For example, as illustrated in FIGURE 3, first portion chassis 106 includes three (3) frills 118 while second portion chassis 108 includes two (2) frills 118. In some examples, the electronics for electronic device 100 are located in second portion chassis 108 so there is only enough room for two (2) frills 118. While flexible heat spreaders 116a and 116b are shown in FIGURE 3 to have the same number and orientation of frills 118, the number, orientation, placement, etc. of frills in flexible heat spreader 116a can be different than one or more of the number, orientation, placement, etc. of frills in flexible heat spreader 116b

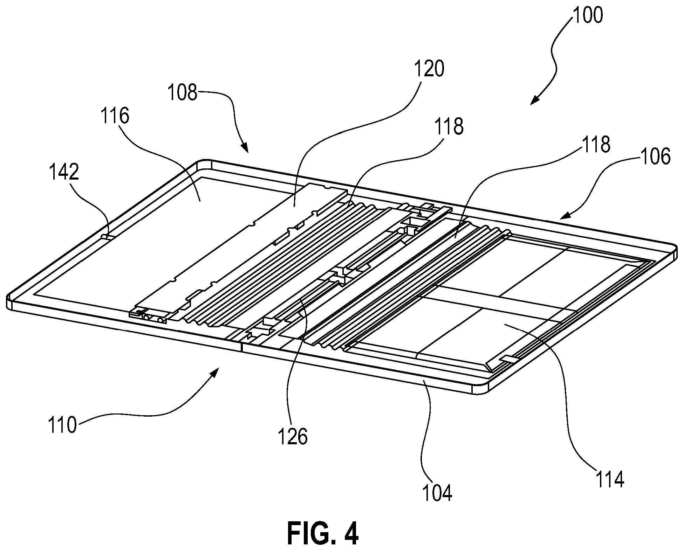

Turning to FIGURE 4, FIGURE 4 is a simplified block diagram cut away view of electronic device 100 configured with a flexible heat spreader, in accordance with an embodiment of the present disclosure. In an example, electronic device 100 can include flexible display 102 (not shown) and chassis 104. Chassis 104 can include first portion chassis 106, second portion chassis 108, and hinge 110. First portion chassis 106 can be rotatably coupled to second portion chassis 108 using hinge 110. Second portion chassis 108 can include one or more heat sources 112 (not shown) and substrate 120. Second portion chassis 108 can include heatsink 114. Heatsink 114 may be an active heatsink or a passive heatsink. Hinge 110 can include a support plate 126.

Flexible heat spreader 116 can extend from one or more heat sources 112 in first portion chassis 106, through hinge 110, and to heatsink 114 in second portion chassis 108. Flexible heat spreader 116 can be secured to chassis 104 (or some other structure or component of electronic device 100) using flexible heat spreader securing means 142. In some examples, flexible heat spreader 116 can extend under support plate 126. Support plate 126 helps to keep flexible heat spreader 116 confined in the Z-direction in hinge 110 as first portion chassis 106 is bent relative to second portion chassis 108. In some specific examples, as first portion chassis 106 is bent relative to second portion chassis 108, if support plate 126 was not present, flexible heat spreader 116 could stick or etch to flexible display 102. Flexible heat spreader 116 can include one or more frills 118. Frills 118 can be configured to accommodate the change in position of the material in flexible heat spreader 116 such that the material in flexible heat spreader 116 is not creased, folded, warped, or otherwise damaged as electronic device 100 is bent or folded (e.g., first portion chassis 106 is bent about hinge 110 relative to second portion chassis 108). The number and location of frills 118 depends on design constraints and the number and location that will help to prevent the material in flexible heat spreader 116 from being creased, folded, warped, or otherwise damaged as electronic device 100 is bent or folded.

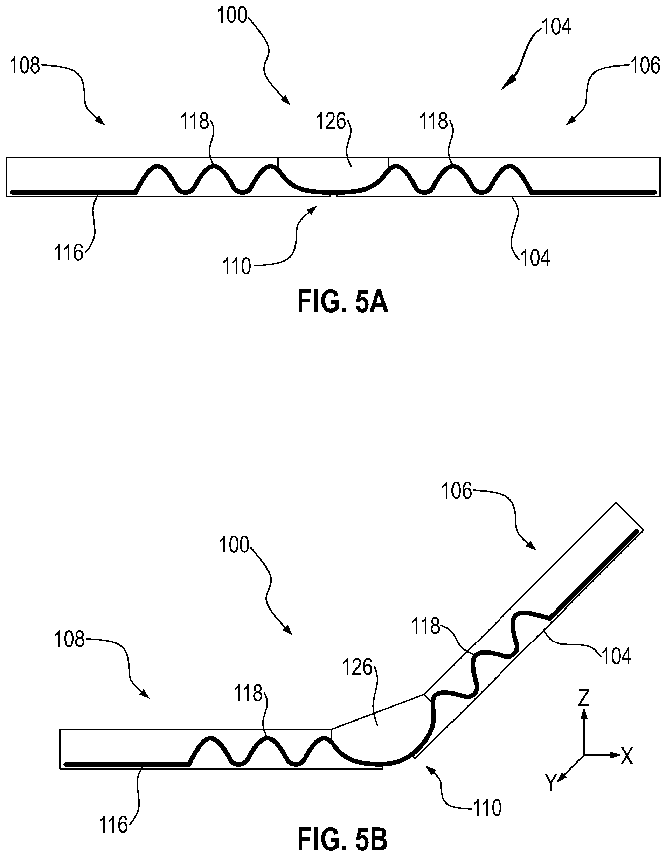

Turning to FIGURE 5A, FIGURE 5A is a simplified block diagram cut away view of electronic device 100 configured with a flexible heat spreader, in accordance with an embodiment of the present disclosure. In an example, electronic device 100 can include chassis 104. Chassis 104 can include first portion chassis 106, second portion chassis 108, and hinge 110. First portion chassis 106 can be rotatably coupled to second portion chassis 108 using hinge 110. Flexible heat spreader 116 can extend from one or more heat sources 112 in first portion chassis 106, through hinge 110, and to heatsink 114 in second portion chassis 108. In an example, flexible heat spreader 116 can be secured to hinge 110 using glue and/or an adhesive. Flexible heat spreader 116 can include frills 118. In some examples, flexible heat spreader 116 can extend under support plate 126. Support plate 126 helps to keep flexible heat spreader 116 confined in the Z-direction in hinge 110 as first portion chassis 106 is bent relative to second portion chassis 108. More specifically, as first portion chassis 106 is bent relative to second portion chassis 108, flexible heat spreader 116 can follow the profile of support plate 126. As illustrated in FIGURE 5A, electronic device 100 is in a flat configuration.

Turning to FIGURE 5B, FIGURE 5B is a simplified block diagram cut away view of electronic device 100 configured with a flexible heat spreader, in accordance with an embodiment of the present disclosure. In an example, electronic device 100 can include chassis 104. Chassis 104 can include first portion chassis 106, second portion chassis 108, and hinge 110. First portion chassis 106 can be rotatably coupled to second portion chassis 108 using hinge 110. Flexible heat spreader 116 can extend from one or more heat sources 112 in first portion chassis 106, through hinge 110, and to heatsink 114 in second portion chassis 108. Flexible heat spreader 116 can include frills 118. In some examples, flexible heat spreader 116 can extend under support plate 126. Support plate 126 helps to keep flexible heat spreader 116 confined in the Z-direction in hinge 110 as first portion chassis 106 is bent relative to second portion chassis 108. More specifically, as first portion chassis 106 is bent relative to second portion chassis 108, flexible heat spreader 116 can follow the profile of support plate 126. As illustrated in FIGURE 5B, first portion chassis 106 is bent or rotated towards second portion chassis 108.

As first portion chassis 106 is bent or rotated towards second portion chassis 108, frills 118 can help prevent the material in flexible heat spreader 116 from creasing, folding, warping, or otherwise being damaged. More specifically, as first portion chassis 106 is bent or rotated towards second portion chassis 108, on the outside of the neutral axis of flexible heat spreader 116, the material of flexible heat spreader 116 is expanding while on the inside of the neutral axis, the material of flexible heat spreader 116 is compressing. This causes the inside surface of flexible heat spreader 116, being inside of the bent neutral axis, to bend to a smaller radius than the outside of the bent neutral axis due to the bending arc length of the inside surface of flexible heat spreader 116 being smaller than the bending arc length of the outside surface of flexible heat spreader 116. Frills 118 can accommodate the change in position of the material in flexible heat spreader 116 such that the material in flexible heat spreader 116 is not creased, folded, warped, or otherwise damaged as first portion chassis 106 is bent or rotated towards second portion chassis 108.

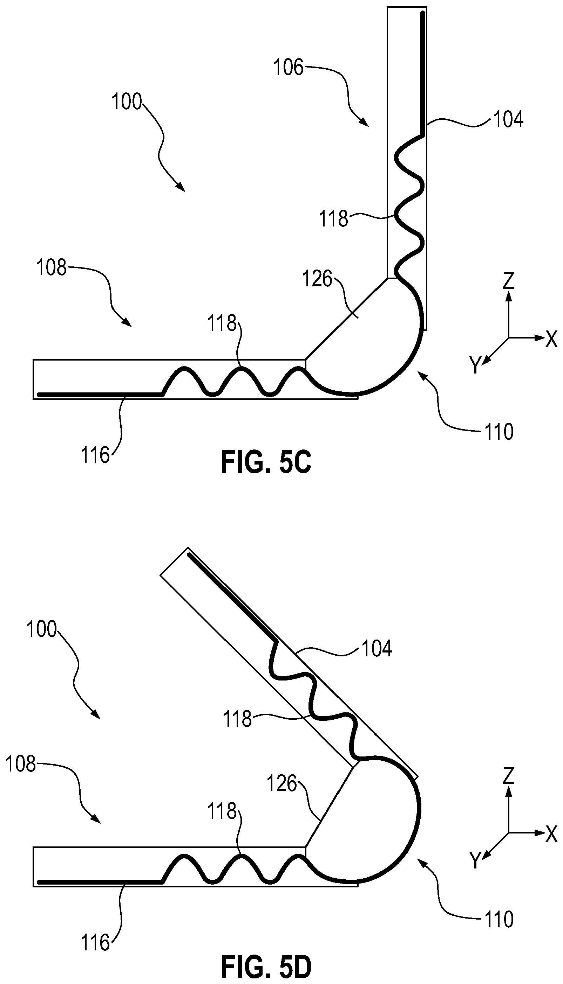

Turning to FIGURE 5C, FIGURE 5C is a simplified block diagram cut away view of electronic device 100 configured with a flexible heat spreader, in accordance with an embodiment of the present disclosure. In an example, electronic device 100 can include chassis 104. Chassis 104 can include first portion chassis 106, second portion chassis 108, and hinge 110. First portion chassis 106 can be rotatably coupled to second portion chassis 108 using hinge 110. Flexible heat spreader 116 can extend from one or more heat sources 112 in first portion chassis 106, through hinge 110, and to heatsink 114 in second portion chassis 108. Flexible heat spreader 116 can include frills 118. In some examples, flexible heat spreader 116 can extend under support plate 126. Support plate 126 helps to keep flexible heat spreader 116 confined in the Z-direction in hinge 110 as first portion chassis 106 is bent relative to second portion chassis 108. More specifically, as first portion chassis 106 is bent relative to second portion chassis 108, flexible heat spreader 116 can follow the profile of support plate 126. As illustrated in FIGURE 5C, first portion chassis 106 is bent or rotated towards second portion chassis 108 and electronic device 100 is in open laptop configuration.

As first portion chassis 106 is bent or rotated towards second portion chassis 108, frills 118 can help prevent the material in flexible heat spreader 116 from creasing, folding, warping, or otherwise being damaged. More specifically, as first portion chassis 106 is bent or rotated towards second portion chassis 108, on the outside of the neutral axis of flexible heat spreader 116, the material of flexible heat spreader 116 is expanding while on the inside of the neutral axis, the material of flexible heat spreader 116 is compressing. This causes the inside surface of flexible heat spreader 116, being inside of the bent neutral axis, to bend to a smaller radius than the outside of the bent neutral axis due to the bending arc length of the inside surface of flexible heat spreader 116 being smaller than the bending arc length of the outside surface of flexible heat spreader 116. Frills 118 can accommodate the change in position of the material in flexible heat spreader 116 such that the material in flexible heat spreader 116 is not creased, folded, warped, or otherwise damaged as first portion chassis 106 is bent or rotated towards second portion chassis 108.

Turning to FIGURE 5D, FIGURE 5D is a simplified block diagram cut away view of electronic device 100 configured with a flexible heat spreader, in accordance with an embodiment of the present disclosure. In an example, electronic device 100 can include chassis 104. Chassis 104 can include first portion chassis 106, second portion chassis 108, and hinge 110. First portion chassis 106 can be rotatably coupled to second portion chassis 108 using hinge 110. Flexible heat spreader 116 can extend from one or more heat sources 112 in first portion chassis 106, through hinge 110, and to heatsink 114 in second portion chassis 108. Flexible heat spreader 116 can include frills 118. In some examples, flexible heat spreader 116 can extend under support plate 126. Support plate 126 helps to keep flexible heat spreader 116 confined in the Z-direction in hinge 110 as first portion chassis 106 is bent relative to second portion chassis 108. More specifically, as first portion chassis 106 is bent relative to second portion chassis 108, flexible heat spreader 116 can follow the profile of support plate 126. As illustrated in FIGURE 5D, first portion chassis 106 is bent or rotated towards second portion chassis 108.

As first portion chassis 106 is bent or rotated towards second portion chassis 108, frills 118 can help prevent the material in flexible heat spreader 116 from creasing, folding, warping, or otherwise being damaged. More specifically, as first portion chassis 106 is bent or rotated towards second portion chassis 108, on the outside of the neutral axis of flexible heat spreader 116, the material of flexible heat spreader 116 is expanding while on the inside of the neutral axis, the material of flexible heat spreader 116 is compressing. This causes the inside surface of flexible heat spreader 116, being inside of the bent neutral axis, to bend to a smaller radius than the outside of the bent neutral axis due to the bending arc length of the inside surface of flexible heat spreader 116 being smaller than the bending arc length of the outside surface of flexible heat spreader 116. Frills 118 can accommodate the change in position of the material in flexible heat spreader 116 such that the material in flexible heat spreader 116 is not creased, folded, warped, or otherwise damaged as first portion chassis 106 is bent or rotated towards second portion chassis 108.

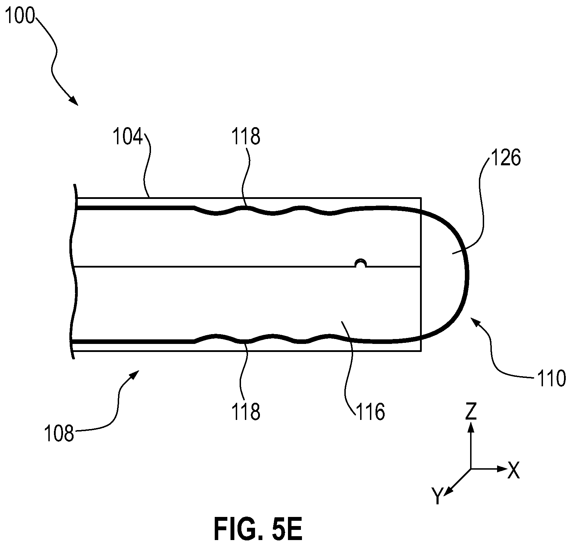

Turning to FIGURE 5E, FIGURE 5E is a simplified block diagram cut away view of electronic device 100 configured with a flexible heat spreader, in accordance with an embodiment of the present disclosure. In an example, electronic device 100 can include chassis 104. Chassis 104 can include first portion chassis 106, second portion chassis 108, and hinge 110. First portion chassis 106 can be rotatably coupled to second portion chassis 108 using hinge 110. Flexible heat spreader 116 can extend from one or more heat sources 112 in first portion chassis 106, through hinge 110, and to heatsink 114 in second portion chassis 108. Flexible heat spreader 116 can include frills 118. In some examples, flexible heat spreader 116 can extend under support plate 126. Support plate 126 helps to keep flexible heat spreader 116 confined in the Z-direction in hinge 110 as first portion chassis 106 is rotated relative to second portion chassis 108. More specifically, as first portion chassis 106 is rotated relative to second portion chassis 108, flexible heat spreader 116 can follow the profile of support plate 126. As illustrated in FIGURE 5E, first portion chassis 106 is bent or rotated towards second portion chassis 108 and electronic device 100 is in a closed configuration.

As first portion chassis 106 is bent or rotated towards second portion chassis 108, frills 118 can help prevent the material in flexible heat spreader 116 from creasing, folding, warping, or otherwise being damaged. More specifically, as first portion chassis 106 is bent or rotated towards second portion chassis 108, on the outside of the neutral axis of flexible heat spreader 116, the material of flexible heat spreader 116 is expanding while on the inside of the neutral axis, the material of flexible heat spreader 116 is compressing. This causes the inside surface of flexible heat spreader 116, being inside of the bent neutral axis, to bend to a smaller radius than the outside of the bent neutral axis due to the bending arc length of the inside surface of flexible heat spreader 116 being smaller than the bending arc length of the outside surface of flexible heat spreader 116. Frills 118 can accommodate the change in position of the material in flexible heat spreader 116 such that the material in flexible heat spreader 116 is not creased, folded, warped, or otherwise damaged as first portion chassis 106 is bent or rotated towards second portion chassis 108.

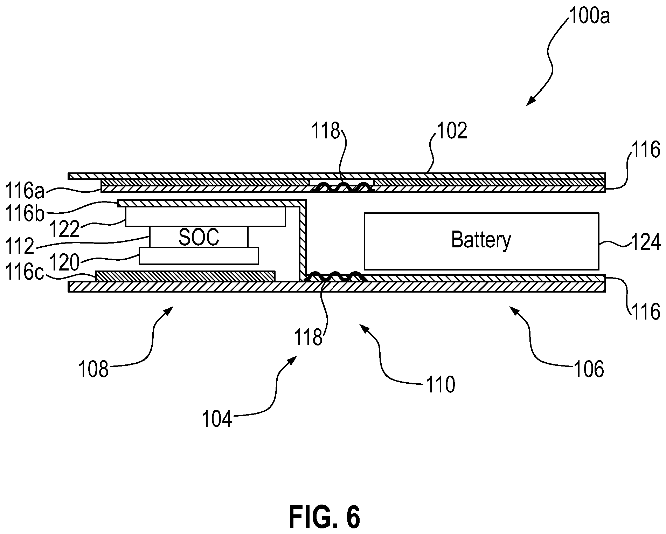

Turning to FIGURE 6, FIGURE 6 is a simplified block diagram of side cutaway view of electronic device 100a configured with a flexible heat spreader, in accordance with an embodiment of the present disclosure. In an example, electronic device 100a can include flexible display 102 and chassis 104. Chassis 104 can include first portion chassis 106, second portion chassis 108, hinge 110, and a plurality of flexible heat spreaders (e.g., flexible heat spreaders 116a-116c). Flexible display 102 may be a FOLED display or some other flexible display. First portion chassis 106 can be rotatably coupled to second portion chassis 108 using hinge 110. First portion chassis 106 can include one or more heat sources 112 (e.g., a system on a chip (SoC)), substrate 120, and cold plate 122. Second portion chassis 108 can include battery 124. Heat source 112 can be over or on substrate 120. Cold plate 122 can be thermally coupled to heat source 112 to help remove heat or thermal energy from heat source 112. Cold plate 122 can be coupled to a flexible heat spreader 116b to help move the heat from heat source 112 away from heat source 112 and to second portion chassis 108.

As illustrated in FIGURE 6, a flexible heat spreader 116a can be located below flexible display 102 and extend from first portion chassis 106, through hinge 110, and to second portion chassis 108. Flexible heat spreader 116b can extend from cold plate 122 in first portion chassis 106, through hinge 110, and to second portion chassis 108. Flexible heat spreader 116c can be under substrate 120 and help transfer heat to chassis 104. Each of flexible heat spreaders 116a and 116b can include one or more frills 118. Frills 118 can be configured to accommodate the change in position of the material in flexible heat spreaders 116a and 116b such that the material in flexible heat spreaders 116a and 116b is not creased, folded, warped, or otherwise damaged as electronic device 100a is bent or folded (e.g., first portion chassis 106 is bent about hinge 110 relative to second portion chassis 108). The number and location of frills 118 depends on design constraints and the number and location that will help to prevent the material in flexible heat spreaders 116a and 116b from being creased, folded, warped, or otherwise damaged as electronic device 100 is bent or folded.

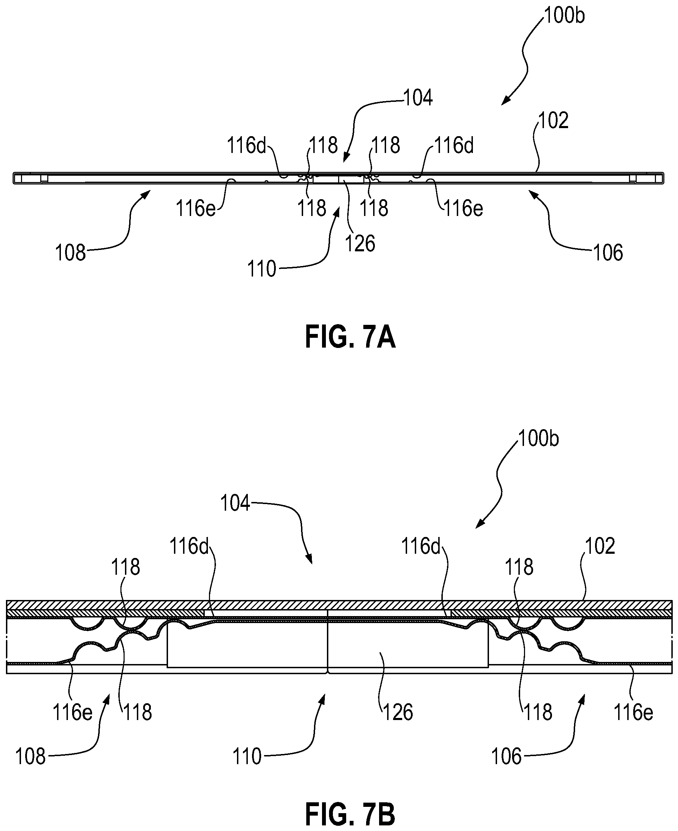

Turning to FIGURES 7A and 7B, FIGURES 7A and 7B are simplified block diagrams of side cutaway view of electronic device 100b configured with a flexible heat spreader, in accordance with an embodiment of the present disclosure. In an example, electronic device 100b can include flexible display 102 and chassis 104. Chassis 104 can include first portion chassis 106, second portion chassis 108, hinge 110, and a plurality of flexible heat spreaders (e.g., flexible heat spreaders 116d and 116e). Flexible display 102 may be a FOLED display or some other flexible display. First portion chassis 106 can be rotatably coupled to second portion chassis 108 using hinge 110. Hinge 110 can include support plate 126.

As illustrated in FIGURES 7A and 7B, a flexible heat spreader 116d can be located below flexible display 102 from first portion chassis 106, through hinge 110, and to second portion chassis 108. Flexible heat spreader 116e can extend from first portion chassis 106, through hinge 110, and to second portion chassis 108. As each of flexible heat spreaders 116d and 116e pass through hinge 110, each flexible heat spreaders 116d and 116e can be supported by support plate 126. Support plate 126 helps to keep flexible heat spreaders 116d and 116e confined in the Z-direction in hinge 110 as first portion chassis 106 is bent relative to second portion chassis 108. In addition, each of flexible heat spreaders 116d and 116e can include one or more frills 118. Frills 118 can be configured to accommodate the change in position of the material in flexible heat spreaders 116a and 116b such that the material in flexible heat spreaders 116a and 116b is not creased, folded, warped, or otherwise damaged as electronic device 100b is bent or folded (e.g., first portion chassis 106 is bent about hinge 110 relative to second portion chassis 108). The number and location of frills 118 depends on design constraints and the number and location that will help to prevent the material in flexible heat spreaders 116a and 116b from being creased, folded, warped, or otherwise damaged as electronic device 100 is bent or folded.

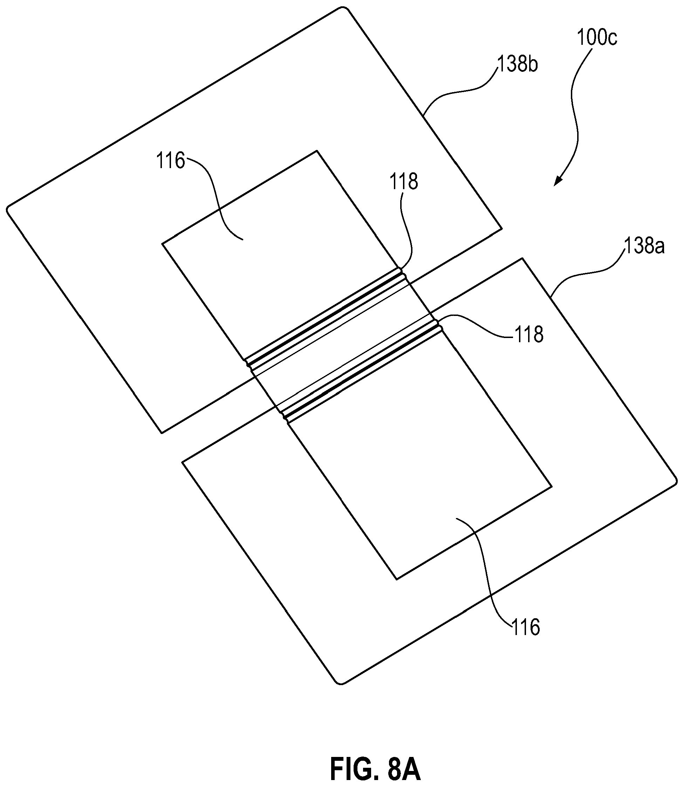

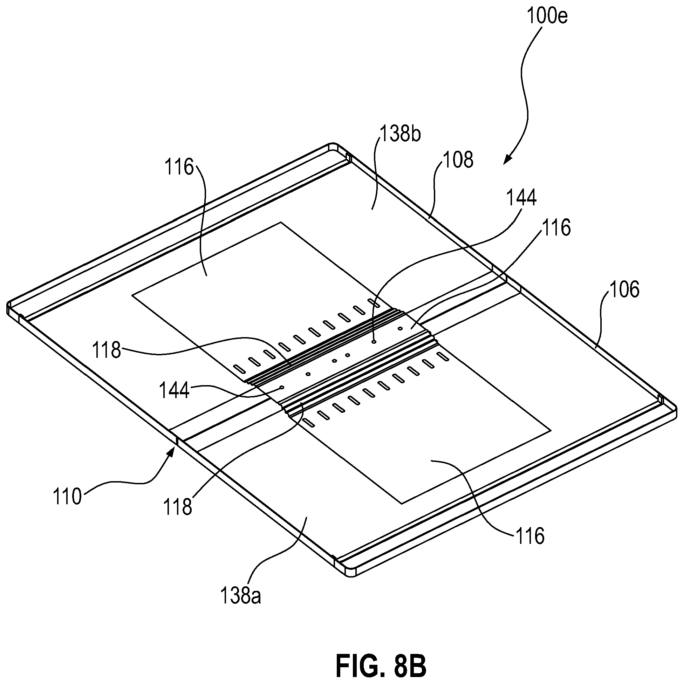

Turning to FIGURE 8A, FIGURE 8A is a simplified block diagram cut away view of a portion of electronic device 100c configured with a flexible heat spreader, in accordance with an embodiment of the present disclosure. Electronic device 100c can include a flexible heat spreader 116. In an example, flexible heat spreader 116 can be secured to a support layer. For example, a portion of flexible heat spreader 116 that will be located in first portion chassis 106 (illustrated in FIGURE 8B) can be secured to support layer 138b with the help of adhesive and/or glue and a portion of flexible heat spreader 116 that will be located in second portion chassis 108 (illustrated in FIGURE 8B) can be on support layer 138a with the help of adhesive and/or glue. In an example, the adhesive/glue can also be used to help secure flexible heat spreader 116 to hinge 110 (not shown).

Flexible heat spreader 116 can include one or more frills 118. Frills 118 can be configured to accommodate the change in position of the material in flexible heat spreader 116 when flexible heat spreader 116 is bent or folded. The number and location of frills 118 depends on design constraints and the number and location that will help to prevent the material in flexible heat spreader 116 from being creased, folded, warped, or otherwise damaged as electronic device 100e is bent or folded.

Turning to FIGURE 8B, FIGURE 8B is a simplified block diagram view of a portion of electronic device 100e configured with a flexible heat spreader, in accordance with an embodiment of the present disclosure. In an example, electronic device 100e can include chassis 104. Chassis 104 can include first portion chassis 106, second portion chassis 108, and hinge 110. First portion chassis 106 can be rotatably coupled to second portion chassis 108 using hinge 110. Flexible heat spreader 116 can extend from one or more heat sources 112 in first portion chassis 106, through hinge 110, and to heatsink 114 in second portion chassis 108. The portion of flexible heat spreader 116 located in first portion chassis 106 can be on support layer 138b with the help of adhesive/glue and the portion of flexible heat spreader 116 located in second portion chassis 108 can be on support layer 138a with the help of adhesive/glue. Hinge 110 can have one or more locating guide holes in the center and flexible heat spreader 116 can have one or more corresponding guide holes 144 that help to position and orient flexible heat spreader 116 in the proper location with respect to hinge 110and can help in the assembly of flexible heat spreader 116. in an example, the Z-movement of flexible heat spreader 116 can be arrested using support plate (e.g., support plate 126 illustrated in FIGURE 4).

Flexible heat spreader 116 can include one or more frills 118. Frills 118 can be configured to accommodate the change in position of the material in flexible heat spreader 116 when first portion chassis 106 is bent or folded relative to second portion chassis 108. The number and location of frills 118 depends on design constraints and the number and location that will help to prevent the material in flexible heat spreader 116 from being creased, folded, warped, or otherwise damaged as electronic device 100e is bent or folded.

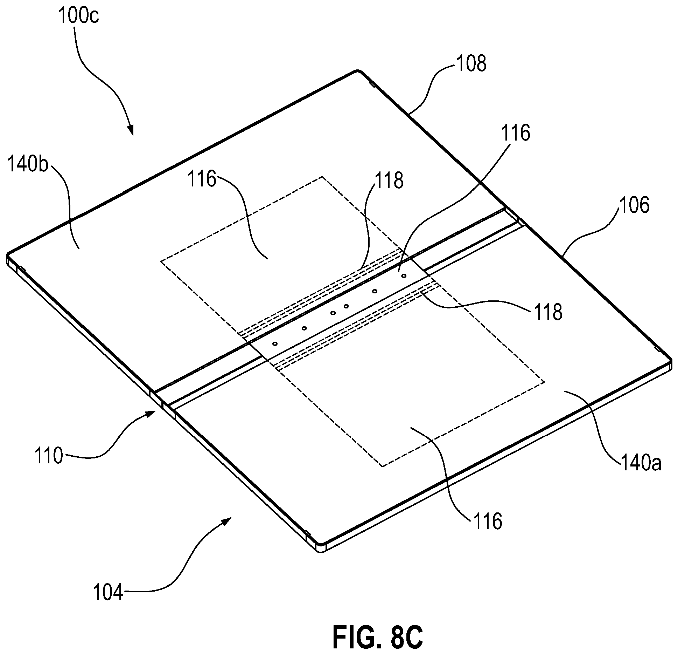

Turning to FIGURE 8C, FIGURE 8C is a simplified block diagram view of a portion of electronic device 100e configured with a flexible heat spreader, in accordance with an embodiment of the present disclosure. In an example, electronic device 100e can include chassis 104. Chassis 104 can include first portion chassis 106, second portion chassis 108, and hinge 110. First portion chassis 106 can be rotatably coupled to second portion chassis 108 using hinge 110. Flexible heat spreader 116 can extend from one or more heat sources 112 in first portion chassis 106, through hinge 110, and to heatsink 114 in second portion chassis 108. In an example, a cover layer can be over flexible heat spreader 116. For example, a cover layer 140a can be over a portion of flexible heat spreader 116 that is located in first portion chassis 106 and a cover layer 140b can be over a portion of flexible heat spreader 116 that is located in second portion chassis 108. Cover layers 140a and 140b can help protect flexible heat spreader 116 and can provide a support for flexible display 102 (not shown).

Flexible heat spreader 116 can include one or more frills 118. Frills 118 can be configured to accommodate the change in position of the material in flexible heat spreader 116 when first portion chassis 106 is bent or folded relative to second portion chassis 108. The number and location of frills 118 depends on design constraints and the number and location that will help to prevent the material in flexible heat spreader 116 from being creased, folded, warped, or otherwise damaged as electronic device 100e is bent or folded.

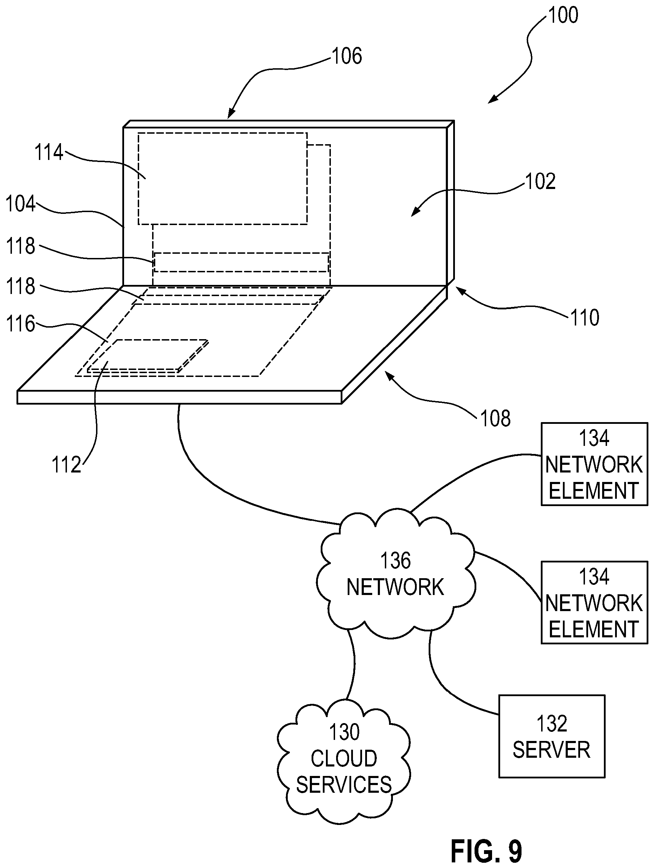

Turning to FIGURE 9, FIGURE 9 is a simplified block diagram of electronic device 100 configured with a flexible heat spreader, in accordance with an embodiment of the present disclosure. As illustrated in FIGURE 9, electronic device 100 is in an open configuration. Electronic device 100 can include flexible display 102 and chassis 104. Chassis 104 can include first portion chassis 106, second portion chassis 108, and hinge 110. Electronic device 100 can also include one or more heat sources 112 and heatsink 114. More specifically, first portion chassis 106 can include one or more heat sources 112 and second portion chassis 108 can include heatsink 114. Heatsink 114 may be an active heatsink or a passive heatsink.

Flexible heat spreader 116 can extend from one or more heat sources 112 in second portion chassis 108, through hinge 110, and to heatsink 114 in first portion chassis 106. Flexible heat spreader 116 can include one or more frills 118. Frills 118 can be configured to accommodate the change in position of the material in flexible heat spreader 116 such that the material in flexible heat spreader 116 is not creased, folded, warped, or otherwise damaged as electronic device 100 is bent or folded.

Electronic device 100 may be in communication with cloud services 130, one or more servers 132, and/or one or more network elements 134 using network 136. In some examples, electronic device 100 may be standalone devices and not connected to network 136 or another device. Elements of FIGURE 9 may be coupled to one another through one or more interfaces employing any suitable connections (wired or wireless), which provide viable pathways for network (e.g., network 136, etc.) communications. Additionally, any one or more of these elements of FIGURE 9 may be combined or removed from the architecture based on particular configuration needs. Network 136 may include a configuration capable of transmission control protocol/Internet protocol (TCP/IP) communications for the transmission or reception of packets in a network. Electronic devices 100 may also operate in conjunction with a user datagram protocol/IP (UDP/IP) or any other suitable protocol where appropriate and based on particular needs.

Turning to the infrastructure of FIGURE 9, network 136 represents a series of points or nodes of interconnected communication paths for receiving and transmitting packets of information. Network 136 offers a communicative interface between nodes, and may be configured as any local area network (LAN), virtual local area network (VLAN), wide area network (WAN), wireless local area network (WLAN), metropolitan area network (MAN), Intranet, Extranet, virtual private network (VPN), and any other appropriate architecture or system that facilitates communications in a network environment, or any suitable combination thereof, including wired and/or wireless communication.

In network 136, network traffic, which is inclusive of packets, frames, signals, data, etc., can be sent and received according to any suitable communication messaging protocols. Suitable communication messaging protocols can include a multi-layered scheme such as Open Systems Interconnection (OSI) model, or any derivations or variants thereof (e.g., Transmission Control Protocol/Internet Protocol (TCP/IP), user datagram protocol/IP (UDP/IP)). Messages through the network could be made in accordance with various network protocols, (e.g., Ethernet, Infiniband, OmniPath, etc.). Additionally, radio signal communications over a cellular network may also be provided. Suitable interfaces and infrastructure may be provided to enable communication with the cellular network.

The term "packet" as used herein, refers to a unit of data that can be routed between a source node and a destination node on a packet switched network. A packet includes a source network address and a destination network address. These network addresses can be Internet Protocol (IP) addresses in a TCP/IP messaging protocol. The term "data" as used herein, refers to any type of binary, numeric, voice, video, textual, or script data, or any type of source or object code, or any other suitable information in any appropriate format that may be communicated from one point to another in electronic devices and/or networks.

Although the present disclosure has been described in detail with reference to particular arrangements and configurations, these example configurations and arrangements may be changed significantly without departing from the scope of the present disclosure. Moreover, certain components may be combined, separated, eliminated, or added based on particular needs and implementations. Additionally, although electronic device 100 has been illustrated with reference to particular elements and operations that facilitate a flexible heat spreader, these elements may be replaced by any suitable architecture and/or processes that achieve the intended functionality of electronic device 100.

Although the present disclosure has been described in detail with reference to particular arrangements and configurations, these example configurations and arrangements may be changed significantly without departing from the scope of the present disclosure. Moreover, certain components may be combined, separated, eliminated, or added based on particular needs and implementations. Additionally, although electronic device 100 has been illustrated with reference to particular elements and operations that facilitate a flexible heat spreader, these elements may be replaced by any suitable architecture and/or processes that achieve the intended functionality of electronic device 100.

Numerous other changes, substitutions, variations, alterations, and modifications may be ascertained to one skilled in the art and it is intended that the present disclosure encompass all such changes, substitutions, variations, alterations, and modifications as falling within the scope of the appended claims. In order to assist the United States Patent and Trademark Office (USPTO) and, additionally, any readers of any patent issued on this application in interpreting the claims appended hereto, Applicant wishes to note that the Applicant: (a) does not intend any of the appended claims to invoke paragraph six (6) of 35 U.S.C. section 112 as it exists on the date of the filing hereof unless the words "means for" or "step for" are specifically used in the particular claims; and (b) does not intend, by any statement in the specification, to limit this disclosure in any way that is not otherwise reflected in the appended claims.

## Claims

1. An electronic device (100) comprising:
a first portion chassis (106);
a second portion chassis (108);
a hinge (110), wherein the hinge (110) pivotably couples the first portion chassis (106) to the second portion chassis (108); and
a flexible heat spreader (116), wherein the flexible heat spreader (116) extends from the second portion chassis (108), through the hinge (110), and to the first portion chassis (106), **characterized in that** the flexible heat spreader (116) includes frills (118) configured to create a slope that is adapted to accommodate deformations in the flexible heat spreader (116) when the first portion chassis (106) is pivoted relative to the second portion chassis (108), wherein the hinge (110) includes a support plate (126) to confine the flexible heat spreader (116) in a Z-direction as the first portion chassis (106) is pivoted relative to the second portion chassis (108), wherein the flexible heat spreader (116) is a flexible graphite sheet, a flexible copper sheet, or a flexible aluminum sheet, wherein the first portion chassis (106) is adapted to rotate from about zero degrees to about one hundred and eighty degrees relative to the second portion chassis (108).

2. The electronic device (100) of Claim 1, further comprising:
a flexible display (102).

3. The electronic device (100) of any of Claims 1 and 2, wherein a number of frills (118) in the first portion chassis (106) is different than a number of fills in the second portion chassis (108).

4. The electronic device (100) of any of Claims 1-3, wherein the flexible heat spreader (116) is configured to transfer heat from a heat source (112) in the second portion chassis (108), through the hinge (110), and to a heatsink in the first portion chassis (106).

5. The electronic device (100) of any of Claims 1-4, further comprising:
a support layer (138b), wherein at least a portion of the flexible heat spreader (116) is secured to the support layer (138b) by an adhesive and/or glue.

6. A method comprising:
rotating a first portion chassis (106) relative to a second portion chassis (108), wherein a flexible heat spreader (116) extends from the second portion chassis (108), through a hinge (110), and to the first portion chassis (106), **characterized in that** the flexible heat spreader (116) includes frills (118) configured to create a slope that is adapted to accommodate deformations in the flexible heat spreader (116) when the first portion chassis (106) is rotated relative to the second portion chassis (108), wherein the hinge (110) includes a support plate (126) to confine the flexible heat spreader (116) in a Z-direction as the first portion chassis (106) is pivoted relative to the second portion chassis (108) , wherein the flexible heat spreader (116) is a flexible graphite sheet, a flexible copper sheet, or a flexible aluminum sheet , wherein the first portion chassis (106) is adapted to rotate from about zero degrees to about one hundred and eighty degrees relative to the second portion chassis (108).

7. The method of Claim 6, wherein a number of frills (118) in a portion of the flexible heat spreader (116) located in the first portion chassis (106) is different than a number of fills (118) in a portion of the flexible heat spreader (116) located in the second portion chassis (108).

8. A flexible heat spreader (116), the flexible heat spreader (116) comprising:
frills (118), wherein the flexible heat spreader (116) extends from a second portion chassis (108), through a hinge (110), and to a first portion chassis (106), **characterized in that** the frills (118) are configured to create a slope that is adapted to accommodate deformations in the flexible heat spreader (116) when the first portion chassis (106) is rotated relative to the second portion chassis (108), wherein the flexible heat spreader (116) extends under a support plate (126) in the hinge (110) and the support plate (126) to help keep the flexible heat spreader (116) confined in a Z-direction as the first portion chassis (106) is rotated relative to the second portion chassis (108), wherein the flexible heat spreader (116) is a flexible graphite sheet, a flexible copper sheet, or a flexible aluminum sheet, wherein the first portion chassis (106) is adapted to rotate from about zero degrees to about one hundred and eighty degrees relative to the second portion chassis (108).

9. The flexible heat spreader (116) of Claim 8, wherein a number of frills (118) in the first portion chassis (106) is different than a number of fills in the second portion chassis (108).

10. The flexible heat spreader (116) of Claim 8 or 9, wherein the flexible heat spreader (116) is configured to transfer heat from a heat source (112) in the second portion chassis (108), through the hinge (110), and to a heatsink in the first portion chassis (106).

## Patentansprüche

1. Elektronische Vorrichtung (100), Folgendes umfassend:
ein erstes Teilchassis (106);
ein zweites Teilchassis (108);
ein Scharnier (110), wobei das Scharnier (110) das erste Teilchassis (106) schwenkbar mit dem zweiten Teilchassis (108) verbindet; und
einen flexiblen Wärmeverteiler (116), wobei sich der flexible Wärmeverteiler (116) vom zweiten Teilchassis (108) durch das Scharnier (110) zum ersten Teilchassis (106) erstreckt, **dadurch gekennzeichnet, dass** der flexible Wärmeverteiler (116) Krausen (118) aufweist, die eingerichtet sind, um eine Neigung zu erzeugen, die angepasst ist, um Verformungen im flexiblen Wärmeverteiler (116) aufzunehmen, wenn das erste Teilchassis (106) relativ zum zweiten Teilchassis (108) geschwenkt wird, wobei das Scharnier (110) eine Trägerplatte (126) aufweist, um den flexiblen Wärmeverteiler (116) in einer Z-Richtung zu begrenzen, wenn das erste Teilchassis (106) relativ zum zweiten Teilchassis (108) geschwenkt wird, wobei der flexible Wärmeverteiler (116) eine flexible Graphitplatte, eine flexible Kupferplatte oder eine flexible Aluminiumplatte ist, wobei das erste Teilchassis (106) eingerichtet ist, um von ungefähr null Grad bis ungefähr einhundertachtzig Grad relativ zum zweiten Teilchassis (108) zu rotieren.

2. Elektronische Vorrichtung (100) nach Anspruch 1, ferner Folgendes umfassend:
eine flexible Anzeige (102).

3. Elektronische Vorrichtung (100) nach einem der Ansprüche 1 und 2, wobei eine Anzahl Krausen (118) im ersten Teilchassis (106) verschieden ist von einer Anzahl Krausen im zweiten Teilchassis (108).

4. Elektronische Vorrichtung (100) nach einem der Ansprüche 1 bis 3, wobei der flexible Wärmeverteiler (116) eingerichtet ist, um Wärme aus einer Wärmequelle (112) im zweiten Teilchassis (108) durch das Scharnier (110) zu einem Kühlkörper im ersten Teilchassis (106) zu übertragen.

5. Elektronische Vorrichtung (100) nach einem der Ansprüche 1 bis 4, ferner Folgendes umfassend:
eine Trägerschicht (138b), wobei mindestens ein Abschnitt des flexiblen Wärmeverteilers (116) durch ein Adhäsiv und/oder einen Klebstoff an der Trägerschicht (138b) befestigt ist.

6. Verfahren, Folgendes umfassend:
Rotieren eines ersten Teilchassis (106) relativ zu einem zweiten Teilchassis (108), wobei sich ein flexibler Wärmeverteiler (116) vom zweiten Teilchassis (108) durch ein Scharnier (110) zum ersten Teilchassis (106) erstreckt, **dadurch gekennzeichnet, dass** der flexible Wärmeverteiler (116) Krausen (118) aufweist, die eingerichtet sind, um eine Neigung zu erzeugen, die angepasst ist, um Verformungen im flexiblen Wärmeverteiler (116) aufzunehmen, wenn das erste Teilchassis (106) relativ zum zweiten Teilchassis (108) rotiert wird, wobei das Scharnier (110) eine Stützplatte (126) aufweist, um den flexiblen Wärmeverteiler (116) in einer Z-Richtung zu begrenzen, wenn das erste Teilchassis (106) relativ zum zweiten Teilchassis (108) geschwenkt wird, wobei der flexible Wärmeverteiler (116) eine flexible Graphitplatte, eine flexible Kupferplatte oder eine flexible Aluminiumplatte ist, wobei das erste Teilchassis (106) eingerichtet ist, um von ungefähr null Grad bis ungefähr einhundertachtzig Grad relativ zum zweiten Teilchassis (108) zu rotieren.

7. Verfahren nach Anspruch 6, wobei eine Anzahl Krausen (118) in einem Abschnitt des flexiblen Wärmeverteilers (116), der im ersten Teilchassis (106) angeordnet ist, verschieden ist von einer Anzahl Krausen (118) in einem Abschnitt des flexiblen Wärmeverteilers (116), der im zweiten Teilchassis (108) angeordnet ist.

8. Flexibler Wärmeverteiler (116), der flexible Wärmeverteiler (116) Folgendes umfassend:
Krausen (118), wobei sich der flexible Wärmeverteiler (116) von einem zweiten Teilchassis (108) durch ein Scharnier (110) zu einem ersten Teilchassis (106) erstreckt, **dadurch gekennzeichnet, dass** die Krausen (118) eingerichtet sind, um eine Neigung zu erzeugen, die angepasst ist, um Verformungen im flexiblen Wärmeverteiler (116) aufzunehmen, wenn das erste Teilchassis (106) relativ zum zweiten Teilchassis (108) rotiert wird, wobei der flexible Wärmeverteiler (116) sich unter einer Trägerplatte (126) im Scharnier (110) erstreckt und die Trägerplatte (126) hilft, den flexiblen Wärmeverteiler (116) in einer Z-Richtung begrenzt zu halten, wenn das erste Teilchassis (106) relativ zum zweiten Teilchassis (108) rotiert wird, wobei der flexible Wärmeverteiler (116) eine flexible Graphitplatte, eine flexible Kupferplatte oder eine flexible Aluminiumplatte ist, wobei das erste Teilchassis (106) eingerichtet ist, um von ungefähr null Grad bis ungefähr einhundertachtzig Grad relativ zum zweiten Teilchassis (108) zu rotieren.

9. Flexibler Wärmeverteiler (116) nach Anspruch 8, wobei eine Anzahl Krausen (118) im ersten Teilchassis (106) verschieden ist von einer Anzahl Krausen im zweiten Teilchassis (108).

10. Flexibler Wärmeverteiler (116) nach Anspruch 8 oder 9, wobei der flexible Wärmeverteiler (116) eingerichtet ist, um Wärme aus einer Wärmequelle (112) im zweiten Teilchassis (108) durch das Scharnier (110) zu einem Kühlkörper im ersten Teilchassis (106) zu übertragen.

## Revendications

1. Dispositif électronique (100) comprenant :
une première partie de châssis (106) ;
une deuxième partie de châssis (108) ;
une charnière (110), la charnière (110) couplant par pivotement la première partie de châssis (106) à la deuxième partie de châssis (108) ; et
un diffuseur de chaleur flexible (116), le diffuseur de chaleur flexible (116) s'étendant depuis la deuxième partie de châssis (108), à travers la charnière (110), et jusqu'à la première partie de châssis (106), **caractérisé en ce que** le diffuseur de chaleur flexible (116) comporte des collerettes (118) conçues pour créer une pente qui est adaptée pour compenser des déformations dans le diffuseur de chaleur flexible (116) quand la première partie de châssis (106) est pivotée par rapport à la deuxième partie de châssis (108), dans lequel la charnière (110) comporte une plaque de support (126) pour confiner le diffuseur de chaleur flexible (116) dans une direction Z lorsque la première partie de châssis (106) est pivotée par rapport à la deuxième partie de châssis (108), dans lequel le diffuseur de chaleur flexible (116) est une feuille de graphite flexible, une feuille de cuivre flexible ou une feuille d'aluminium flexible, dans lequel la première partie de châssis (106) est adaptée pour tourner d'environ zéro degré à environ cent quatre-vingts degrés par rapport à la deuxième partie de châssis (108) .

2. Dispositif électronique (100) selon la revendication 1, comprenant en outre :
un écran flexible (102).

3. Dispositif électronique (100) selon l'une quelconque des revendications 1 et 2, dans lequel un nombre de collerettes (118) dans la première partie de châssis (106) est différent d'un nombre de collerettes dans la deuxième partie de châssis (108).

4. Dispositif électronique (100) selon l'une quelconque des revendications 1 à 3, dans lequel le diffuseur de chaleur flexible (116) est conçu pour transférer la chaleur issue d'une source de chaleur (112) dans la deuxième partie de châssis (108) à travers la charnière (110) et jusqu'à un dissipateur thermique dans la première partie de châssis (106).

5. Dispositif électronique (100) selon l'une quelconque des revendications 1 à 4, comprenant en outre :
une couche de support (138b), au moins une partie du diffuseur de chaleur flexible (116) étant fixée à la couche de support (138b) par un adhésif et/ou de la colle.

6. Procédé comprenant :
la rotation d'une première partie de châssis (106) par rapport à une deuxième partie de châssis (108), dans lequel un diffuseur de chaleur flexible (116) s'étend depuis la deuxième partie de châssis (108), à travers une charnière (110), et jusqu'à la première partie de châssis (106), **caractérisé en ce que** le diffuseur de chaleur flexible (116) comporte des collerettes (118) conçues pour créer une pente qui est adaptée pour compenser des déformations dans le diffuseur de chaleur flexible (116) quand la première partie de châssis (106) est tournée par rapport à la deuxième partie de châssis (108), dans lequel la charnière (110) comporte une plaque de support (126) pour confiner le diffuseur de chaleur flexible (116) dans une direction Z lorsque la première partie de châssis (106) est pivotée par rapport à la deuxième partie de châssis (108), dans lequel le diffuseur de chaleur flexible (116) est une feuille de graphite flexible, une feuille de cuivre flexible ou une feuille d'aluminium flexible, dans lequel la première partie de châssis (106) est adaptée pour tourner d'environ zéro degré à environ cent quatre-vingts degrés par rapport à la deuxième partie de châssis (108).

7. Procédé selon la revendication 6, dans lequel un nombre de collerettes (118) dans une partie du diffuseur de chaleur flexible (116) située dans la première partie de châssis (106) est différent d'un nombre de collerettes (118) dans une partie du diffuseur de chaleur flexible (116) située dans la deuxième partie de châssis (108).

8. Diffuseur de chaleur flexible (116), le diffuseur de chaleur flexible (116) comprenant :
des collerettes (118), le diffuseur de chaleur flexible (116) s'étendant depuis une deuxième partie de châssis (108), à travers une charnière (110), et jusqu'à une première partie de châssis (106), **caractérisé en ce que** les collerettes (118) sont conçues pour créer une pente qui est adaptée pour compenser des déformations dans le diffuseur de chaleur flexible (116) quand la première partie de châssis (106) est tournée par rapport à la deuxième partie de châssis (108), le diffuseur de chaleur flexible (116) s'étendant sous une plaque de support (126) dans la charnière (110) et la plaque de support (126) servant à aider à maintenir le diffuseur de chaleur flexible (116) confiné dans une direction Z lorsque la première partie de châssis (106) est tournée par rapport à la deuxième partie de châssis (108), le diffuseur de chaleur flexible (116) étant une feuille de graphite flexible, une feuille de cuivre flexible ou une feuille d'aluminium flexible, la première partie de châssis (106) étant adaptée pour tourner d'environ zéro degré à environ cent quatre-vingts degrés par rapport à la deuxième partie de châssis (108).

9. Diffuseur de chaleur flexible (116) selon la revendication 8, dans lequel un nombre de collerettes (118) dans la première partie de châssis (106) est différent d'un nombre de collerettes dans la deuxième partie de châssis (108).

10. Diffuseur de chaleur flexible (116) selon la revendication 8 ou 9, le diffuseur de chaleur flexible (116) étant conçu pour transférer la chaleur issue d'une source de chaleur (112) dans la deuxième partie de châssis (108) à travers la charnière (110) et jusqu'à un dissipateur thermique dans la première partie de châssis (106).
